# EUROPEAN PATENT SPECIFICATION

(11) **EP 3 408 916 B1**
(45) Date of publication and mention of the grant of the patent: **06.07.2022**
(21) Application number: 17704305.6
(22) Date of filing: 30.01.2017
(51) Int. Cl.: H02J 7/00, G01R 31/36, H01M 10/48

(54) **AUTOMATIC ADDRESSING OF BATTERY NODES IN A BATTERY SYSTEM**
AUTOMATISCHE ADRESSIERUNG VON BATTERIEKNOTEN IN EINEM BATTERIESYSTEM
ADRESSAGE AUTOMATIQUE DES NOEUDS DE BATTERIE DANS UN SYSTÈME DE BATTERIE

(30) Priority: 29.01.2016 US 201662288506 P
(43) Date of publication of application: 05.12.2018
(73) Proprietor: Form Energy, Inc., Somerville MA 02143 (US)
(72) Inventor: KRISHNAN, Ramkumar, Scottsdale, AZ 85260 (US); BANUELOS SOLIS, Javier Eduardo, Scottsdale, AZ 85258 (US); FINK, Shawn, Sunnyvale, CA 94087 (US); GOLDBERG, Jonathan, Scottsdale, AZ 85258 (US); NADEN, Mark, Scottsdale, AZ 85260 (US)
(74) Representative: Beck Greener LLP
(86) International application number: PCT/IB2017/050496
(87) International publication number: WO 2017/130175

(56) References cited:
- EP-A2- 2 571 200
- DE-A1-102006 038 678
- DE-A1-102012 204 958
- US-A- 6 094 053
- US-A1- 2014 223 048

## Description

### Field of the Invention

The present invention relates to a method of assigning a plurality of addresses to a plurality of battery nodes in a battery system.

### Background of the Invention

Battery systems employing a plurality of batteries are often monitored by a master controller that receives a unique address identifier from each battery. A master controller may receive various metrics related to each battery in the system such as voltage, temperature, state of charge and the like. A master controller may comprise a plurality of inputs/outputs for receiving and sending signals to each of the individual batteries in the system. Each battery may have a module that transmits battery metrics to the master controller. The wiring between the master controller and each battery of the prior art systems can quickly become very complex and hard to manage. When a battery has to replaced, rewiring to the master controller can be difficult. In addition, each battery in the system has to have a unique address for the master controller to recognize and discern the metrics of each battery. When a battery has to be replaced, it can be difficult to determine which battery relates to the battery that has been identified by the master controller for replacement. US-A-6,094,053 describes a system in which addresses are assigned to electronic modules coupled to batteries based on the potentials of corresponding nodes within the modules. US-A-2009/0207680 relates to a rechargeable storage device including memory cells to which unique addresses are assigned based on a sensor device used to check operability of the cell. EP-A-2,571,200 describes a series of slave modules coupled to a master module in series. Addresses are assigned to each of the slave modules by the controller at which point a switch of the module is closed to allow communication with the next slave module in the series. US-A-2014/0223048 also describes a system in which nodes are connected to a central control unit in series. A second bus interface is provided to provide an alternative communication route between the controller and the nodes. US-A-2015/0064513 relates to a battery including a plurality of monitoring units connected to battery modules. The system includes a first communication network configured to transmit data from or to the battery control unit and a second communication network configured to transmit an activation signal to a monitoring unit to activate the monitoring unit.

### Summary of the Invention

There is provided a method of automatically assigning a plurality of addresses to a plurality of battery nodes in a battery system and a battery system configured for assigning a plurality of addresses to a plurality of battery nodes, as defined in the claims. There is disclosed a method of assigning a plurality of addresses to a plurality of battery nodes in a battery system. The battery system comprises an addressing power supply for outputting an addressing power signal and a plurality of battery nodes 1 to N connected in series and each coupled to at least one battery. Each node comprises a positive terminal, a negative terminal, and a bypass switch between the positive and negative terminals. One of the terminals is also an addressing power signal receiving terminal. Each node further comprises a battery module comprising a processor, a sensor coupled to the processor for sensing the addressing power signal when applied to the addressing power signal receiving terminal thereof and a communication transceiver coupled to the processor for transmitting and receiving data. The system also comprises a master controller comprising a processor and a communication transceiver for transmitting and receiving data. The transceivers of the master controller and each battery module are configured for communication with each other.

The method is performed with all the by-pass switches of the battery nodes being initially open and each node being de-coupled from power connection to the at least one battery associated therewith. The method comprises:
outputting the addressing power signal from the addressing power supply to the addressing power signal receiving terminal of the battery node 1;
at each battery node in sequential order for nodes 1 to N as the addressing power signal is applied to the addressing power signal terminal thereof, performing a node address assignment comprising:
   (i) sensing the addressing power signal at the addressing power signal receiving terminal thereof;
   (ii) assigning a next available address in the plurality of addresses to the battery node;
   (iii) transmitting a message confirming assignment of the address via the communication transceiver of the node to the communication transceivers of the master controller and/or each other node;
wherein during the node address assignment the by-pass switch of the battery node is closed to by-pass the node for at least node 1 to N-1 to apply the addressing power signal to the addressing power signal receiving terminal of the subsequent node.

In some embodiments, the master controller may govern the node address assignment in a more centralized manner. For example, the message confirming assignment of the address is transmitted to the master controller, and in response the master controller transmits a message to the nodes identifying the next available address for assignment in the subsequent node address assignment. (For the first assignment, since no nodes have been assigned the master controller may transmit the message for the initial node address at the beginning as well, i.e., not in response to a confirmation message). Thus, the master controller is responsible for controlling which addresses are to be assigned, and for informing the nodes (particularly the unassigned ones) what the next available address is. The node receiving the addressing power signal at its address power receiving signal thus will use that address.

In other embodiments, the node address assignment logic can be distributed to the nodes. That is, the nodes' processors may be pre-populated with the available addresses or logic for the selecting the same. For example, the message confirming assignment of the address to one node is sent to each other node, and in response each unassigned node's processor identifies the next available address for assignment in the subsequent node address assignment. (For the first assignment, the nodes may also use the same approach for assignment of the initial node address, i.e., not in response to a confirmation message). Thus, the master controller does not need to inform the nodes what the next available address is, because the nodes themselves can make that determination on their own based on the node assignment being the initial one or having received that a prior address has been assigned.

In such embodiments, the method may also include, in response to receiving the message confirming assignment of the address, the master controller identifying the address as assigned in its processor. That enables the master controller to record what node addresses have been assigned during the method.

In any embodiment, the sensing of the addressing power signal at the addressing power signal receiving terminal thereof may optionally comprise sensing a threshold voltage above a threshold level at the addressing power signal receiving terminal.

Another aspect of the invention provides a system that is configured to perform the addressing method. Again, the system may have the logic more centralized to the master controller, or more aspects of it may be distributed to the controllers, as mentioned above. The system comprises: an addressing power supply for outputting an addressing power signal and a plurality of battery nodes 1 to N connected in series and each coupled to at least one battery. Each node comprises a positive terminal, a negative terminal, and a bypass switch between the positive and negative terminals, one of the terminals also being an addressing power signal receiving terminal. Each node further comprises a battery module comprising a processor, a sensor coupled to the processor for sensing the addressing power signal when applied to the addressing power signal receiving terminal thereof and a communication transceiver coupled to the processor for transmitting and receiving data. A master controller comprises a processor and a communication transceiver for transmitting and receiving data. The transceivers of the master controller and each battery module are configured for communication with each other.

The battery system is configured to perform the method of assigning the plurality of addresses to the battery nodes with all the by-pass switches of the battery nodes being initially open and each node being de-coupled from power connection to the at least one battery associated therewith by:
the master controller being configured to cause the addressing power supply to output the addressing power signal from the addressing power supply to the addressing power signal receiving terminal of the battery node 1;
each battery node being configured to perform a node address assignment, in sequential order for nodes 1 to N as the addressing power signal is applied to the addressing power signal terminal thereof, comprising:
   (i) sensing the addressing power signal at the addressing power signal receiving terminal thereof with the sensor thereof;
   (ii) storing a next available address in the plurality of addresses in the processor thereof;
   (iii) transmitting a message confirming assignment of the address via the communication transceiver thereof to the communication transceivers of the master controller and/or each other node.

The processor of each node is configured to close the by-pass switch thereof during the node address assignment to by-pass the node for at least node 1 to N-1 to apply the addressing power signal to the addressing power signal receiving terminal of the subsequent node.

Other objects, features, and advantages of the present application will become apparent from the following detailed description, the accompanying drawings, and the appended claims.

### Brief Description of the Drawings

Figure 1 shows an exemplary diagram of automatic battery cell addressing system having a master controller connected to individual battery modules on each of the batteries and all of the bypass switches open;
Figure 2 shows a diagram of a cell addressing algorithm for the master controller;
Figure 3 shows a diagram of a cell addressing algorithm for a battery module;
Figure 4 shows an exemplary diagram of automatic battery cell addressing system having the first battery node with a closed bypass switch after being addressed automatically addressed by the master controller; and
Figure 5 shows an exemplary diagram of automatic battery cell addressing system having the first and second battery node with closed bypass switches after being automatically addressed by the master controller.

### Detailed Description of the Illustrated Embodiment(s)

The invention is directed to a method of automatically addressing a plurality of batteries in a battery system. In an exemplary embodiment, a plurality of battery nodes connected in series are automatically addressed. The automatic addressing system utilizes an address power supply that is coupled to each of the battery nodes and a bypass switch to acknowledge each of the battery nodes and provide a unique address. In an exemplary embodiment, the master controller addresses each of the plurality of battery nodes is a sequential in order. For example, a first battery node may have a first node index value of n and a second battery node, adjacent said first battery node, may have a second node index value that is one integer offset from the first node index value, such as n-1, n+1 or the like. The addresses need not be sequentially adjacent integers, and can be any other identification data unique to each node.

The address power supply provides an addressing power signal, which in some embodiments may have an address voltage that is greater than a threshold voltage through a powerline connection to the plurality of battery nodes. When the address power supply is activated or connected by the master controller, and all the battery nodes have their bypass switches open, the addressing power signal is applied to a terminal (referred to for convenience as the address power signal receiving terminal) of the first battery node (battery node 1) in the series of battery nodes, and its voltage greater than the threshold value can be detected at the addressing power signal receiving terminal. The first node is assigned the first address available from the plurality, and the first node's bypass switch is closed to that its terminals are shorted and addressing power signal is applied to the addressing power signal receiving terminal of the next node (node 2). This is repeated, with each subsequent node 2 to N being assigned the next available address from the plurality. Knowledge that a node has been assigned an address is transmitted through the system by wired or wireless communication, as discussed below, so each battery node and/or the master controller recognizes that an address has been used and that it should use the next available address.

Each of the battery nodes, described herein, comprises a positive terminal, a negative terminal, a bypass switch configured between the positive and negative terminal and couple to said powerline, and a battery module. A battery module comprises a microprocessor having a control program and/or circuit logic, a sensor that measures a node voltage or other parameter, a communication transceiver (e.g., electrically coupled to the Lin Bus connection line with an analog-to-digital converter that converts the node voltage to a digital node voltage for transmission to the master controller on the Lin Bus connection line). Each of the battery modules communicates with the master through the Lin Bus connection line or other communication means and transmits/receives data and/or commands to/from the master controller and other nodes. A powerline is coupled to the positive terminals and negative terminals of the plurality of batteries in series.

A master controller comprises a microprocessor having a master program configured therein and/or circuit logic, and a communication transceiver (e.g., electrically coupled with each of the battery nodes through a Lin Bus connection line). A master controller controls an address power supply that is electrically coupled to the battery nodes through the powerline and is configured to provide an addressing power signal (which may be detected as an referred to as an address voltage that is above a threshold voltage). The master controller will activate the address power supply for addressing purposes. A separate master power supply may provide power to the master and to each of the plurality of battery nodes through a node powerline. Power to the master power supply and the address power supply may be provided by a connection to a VDC Bus.

In an exemplary method, a plurality of batteries are connected in series and the master controller transmits an "Address Start" signal to the plurality of battery nodes through said Lin Bus connection line. In an exemplary embodiment, the Lin Bus connection line is coupled in parallel to each of the battery nodes, thereby eliminating the need for a separate and distinct connection line from the master to each of the battery nodes. This simplifies the wiring and reduces complexity. Each of the plurality of battery nodes receives the "Address Start" signal from the master controller sets their respective address to NULL. The by-pass switches should be open at this point, as nodes should normally have those switches open during charge and re-charge, absent there being a reason for by-passing a cell. The Address Start signal (or a related signal sent separately) may also signal all the nodes to open or ensure their by-pass switches are open in the event any are closed. The master controller then turns on the address power supply that provides an address voltage to the battery nodes that is greater than a threshold voltage, such as 7V and wherein the threshold value is greater than 3.5V, for example. The first battery node is the only battery node having a voltage that is substantially equal to the address voltage since all of the bypass switches are open. The master controller transmits a "Program Address" command to the plurality of battery nodes connected in series and each battery node measures their respective node voltage. The first battery node, having a measured node voltage above said threshold voltage, transmits a "Voltage Acknowledgment" to the master controller through the module interconnect transceiver within a threshold time period, such as one second. The first battery node then stores a first node index value, transmitted by the master controller, in the first battery node's microprocessor. The first battery node then closes the first battery node bypass switch and transmits an "Address Acknowledgment" to the master controller through said Lin Bus connection line that the node index value has been stored.

After the first battery node has been addressed, the first battery node's bypass switch is closed, thereby causing the second battery node to also have a node voltage that is above the threshold voltage. The power from the address power supply is now flowing through the first battery node's bypass switch to the second battery node. The second battery node's bypass switch is still open, as the second battery node has not been addressed. After receiving the "Address Acknowledgment " from the first battery node, the master then transmits a subsequent Program Address command to all of said plurality of battery nodes connected in series. The second battery node, now having a node voltage greater than the threshold voltage sends a Voltage Acknowledgment to the master through the Lin Bus connection line within the threshold time period. The second battery node then stores a second node index value, provided by the master, that is an integer different, e.g., one integer less, than the first node index value. The second battery node index value may be n-1, wherein the first battery node index value is n, for example. The second battery node then closes the bypass switch and transmits an Address Acknowledgment to the master controller through said Lin Bus connection line that the second node index value has been stored. These steps are repeated for each of the battery nodes connected in series wherein each successive battery node is addresses in sequential order with sequential node index values. When the node index value has reached zero or a preset value, the master will then transmits an address stop signal to all of the battery nodes through the Lin Bus Connection line and turns off the address power supply.

The node addresses may be decremented until the last battery node receives and stores a node address of one. The battery node may be programed to not close the bypass switch when the node address is one. A battery module having a control program that leaves the last bypass switch open when it stores a node address keeps the circuit from shorting and enables the automatic addressing protocol, regardless of the number of battery nodes configured in series. In another exemplary method, the master controller transmits an address stop signal to all of the battery nodes through the Lin Bus Connection line and turns off the address power supply when the master does not receive a Voltage Acknowledgment within the threshold time.

Certain exemplary embodiments of the present invention are described herein and are illustrated in the accompanying figures. The embodiments described are only for purposes of illustrating the present invention and should not be interpreted as limiting the scope of the invention. Other embodiments of the invention, and certain modifications, combinations and improvements of the described embodiments, will occur to those skilled in the art and all such alternate embodiments, combinations, modifications, improvements are within the scope of the present invention.

### Definitions:

Power line, as used herein, is a line, wire, that couples the battery terminals of the plurality of batteries in series and is coupled to a load to provide electrical current to said load from the batteries.

Threshold voltage, as used herein, is a voltage value used by a battery node to detect that it has received the addressing power signal, and thus enable addressing of that node.

A threshold time period, as used herein, is a time period measured between identifiable events relating to the addressing of a node. For example, the time period may be between the transmission of the "Program Address" command by the master controller and receipt of a Voltage Acknowledgment from an addressed battery nodes by the master. The time period may also be between a confirmation message from an one node that it has been assigned an address (which indicates the subsequent node is to be addressed next), and the confirmation message from that subsequent node that it has been addressed. A threshold time period may be a fraction of a second, about one second or more, about two seconds or more, about five second or more and the like. The period is selected to allow sufficient time for the node addressing to occur, and exceeding the time period would indicate an error has occurred in the node addressing process.

A battery node, as used herein, may be coupled to a single battery or a plurality of batteries (i.e., a battery module or set). For example, a first battery node may have only a single battery coupled thereto or may have two or more batteries connected in series or in parallel coupled to a single battery node.

Battery, as used herein, may be any suitable type of battery including, but not limited to, lead-acid, metal-air such as zinc-air for example, lithium, nickel-cadmium and the like.

Preset node index value, as used herein, is a node index value that triggers the master to end the address protocol. This is used in systems where the number of nodes in the series is already known (either by pre-programming, or from knowledge having been acquired about the number of nodes in the series during a prior address process). For example, a preset node index value may be zero and the first battery node in a series of 16 batteries may be addressed with a node index value of sixteen, the second node addresses with a node index value of fifteen, and so on. When the last battery node is addressed with a node index value of one, the subsequent and decremented node index value is now zero. This triggers the master to send a "Stop Address" command to the battery nodes and turn off the address power supply.

An address of a node refers to identification unique to that cell within the battery system. The format of the address is not critical to the practice of the invention. Typically, the address will be a set of binary bits stored both in the relevant node and the master controller, so that the master controller knows that messages from that node are associated with that node, and the node that knows that any messages from the master controller for its address are intended for that node. While the description herein is using more simplistic integers 1 to N herein for description, the encoding of the addresses themselves may be more complex, such as data fields including multiple bits. For example, an 8 bit field would enable up to 256 unique addresses in one system.

A message in any data or command communicated between components, such as the nodes and the master controller.

Not all embodiments will use the pre-set node index value, and some embodiments may be open-ended in the sense that any number of batteries (within the capacity of the system and controller) may be included. In such embodiments, the same controller could be coupled to e.g,. 12, 16 or 20 battery nodes in series, and the addressing may increment the addresses assigned to the final value. For example, if the controller is coupled to a series of 12 battery nodes, the sequence of addresses assigned will start at 1 and end at 12. The same controller may be coupled to 20 battery nodes in series, and the sequence of addresses assigned will start at 1 and end at 20. This enables the same controller to be used in battery systems of different size and configuration without having to preprogram the system as to a specific number of battery nodes in the series.

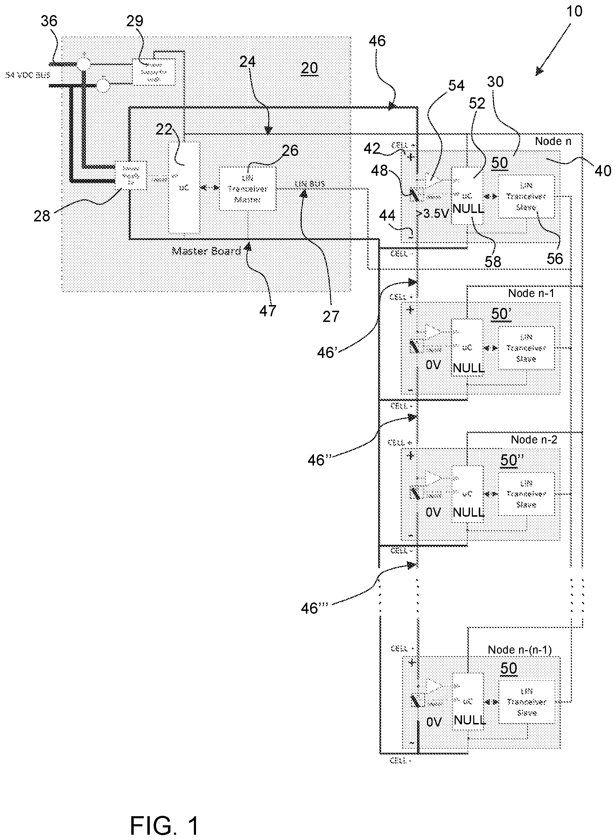

As shown in FIG. 1, an exemplary master controller 20 comprises a processor, such as a microprocessor 22, which may be general purpose or an ASIC, and a communication transceiver, which may be a master interconnect transceiver 26. The master interconnect transceiver 26 is coupled with the communication transceivers (which may be module interconnect transceivers) 56 of the individual battery modules 50, or nodes 40, through a LIN Bus connection line 27 that transmits and receives signals from the battery modules. A LIN Bus is not required. Other network busses may be used, such as a CAN bus. Similarly, the communication between the master controller transceiver 26 and the transceivers 56 on the battery nodes 40 may be wireless. For example, Bluetooth transceivers could be used, or transceivers using other protocols, such as Wi-Fi, IEEE 802, wireless USB, etc. Thus, although the disclosed embodiments are described below as using a LIN Bus, it should be understood that any communication protocol and system may be used among the nodes 40 and controller 20.

Each battery node 40 may comprise one or more batteries 30. The master controller is optionally coupled with a power supply 29 that provides power to the master controller and to the battery modules through the node powerline 24 during the addressing process. Since the batteries may be decoupled from their node terminals during the addressing, external power such as power supply 29 is used. The batteries are preferably decoupled so the terminals can be used for the addressing functionality without the potential of the battery itself interfering with detection of the addressing power signal. The power supply be of any type, and may be a battery of a circuit element that supplies power from the external grid to which the system is connected. A ground 47 is shown being coupled with the master, as well as each of the battery modules 50, 50ʺ, 50‴, etc. A separate addressing power supply 28 is also shown, and may likewise be of any type. The addressing power supply 28 and the power supply 29 also may be combined in the same component, and the power used for the general power and addressing purposes may be drawn from the same supply in some embodiments.

The automatic cell addressing system 10 is electrically connected with a VDC Bus 36 that provides electrical power to the system during addressing. The master controller controls the power delivery from the address power supply 28 to the battery modules and power is supplied through the node power line 46. The address power supply is used in the cell addressing algorithm to confirm a battery node before addressing said node by the master controller and is coupled to the powerline that is coupled to each of the batteries. Each of the battery modules 50, 50', etc. is electrically coupled with the power line 46 and the ground 47. Each individual battery module controls a bypass switch 48 that is configured between the positive 42 and negative terminal 44 of the battery 30.

As shown in FIG. 1, all of the bypass switches are initially open at the beginning of the addressing process, thereby causing only battery node 1 to have the voltage as supplied by the address power supply. The voltage is the voltage of the addressing power signal output by the addressing power supply 28. As mentioned above, other parameters, such as current, induction or the like, may be measured, and reference to sensing or measuring a voltage herein is exemplary. Initially, the addressing power signal is applied to the positive terminal of the first node (node 1 of nodes 1 to N), and the positive terminal of each subsequent node 40 will receive the addressing power signal as the node addresses are assigned and the by-pass switches are closed. The terminal to which the power signal is applied (either initially in the case of the first node, or subsequently in the case of the second through Nth nodes) may be referred to as the addressing power signal receiving terminal for convenience. In other embodiments, the arrangement may be reversed, and the addressing power signal receiving terminal could be the negative terminal of a battery node.

The voltage applied to the addressing power signal of each battery node 40 is measured by a sensor, such as a voltage sensor circuit 54 and an analog-to-digital converter 58 included in processor 52, which optionally may convert the voltage reading from the circuit into a digital signal that is relayed to the master controller on the Lin Bus connection line 27 by the module interconnect transceiver 56. Each battery module comprises the processor 52, which may be microprocessor 52 such as a general purpose one or an ASIC, for controlling the bypass switch and receiving and generating signals for communication with the master controller.

As shown in FIG. 1, with all of the battery nodes having an open bypass switch, the first battery node 50 has a node voltage as provided by the address power supply at the addressing power receiving terminal greater than a threshold value, or greater than 3.5V, for example. The other battery nodes have a node voltage below the threshold value, or substantially zero volts since first node bypass switch is open, thereby preventing power from the address power supply from reaching the subsequent battery nodes. At the outset of the addressing process, all of the battery nodes may have set their node address to NULL, as shown in FIG. 1. NULL may refer to having an address of zero or some arbitrary value consistent with not having an assigned address yet, data or a flag indicating no address has been assigned, or any other data or information indicating the node is not assigned an address in the process.

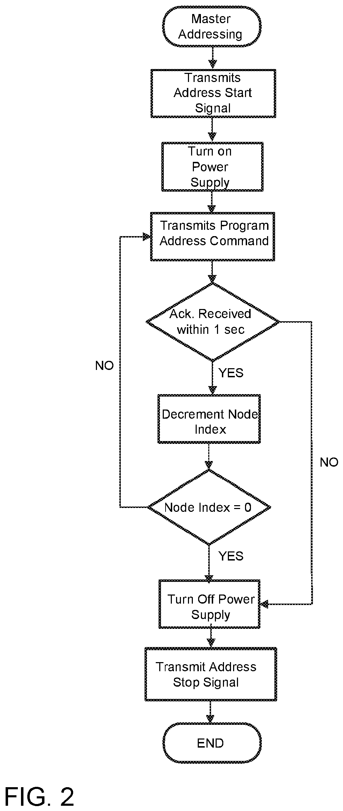

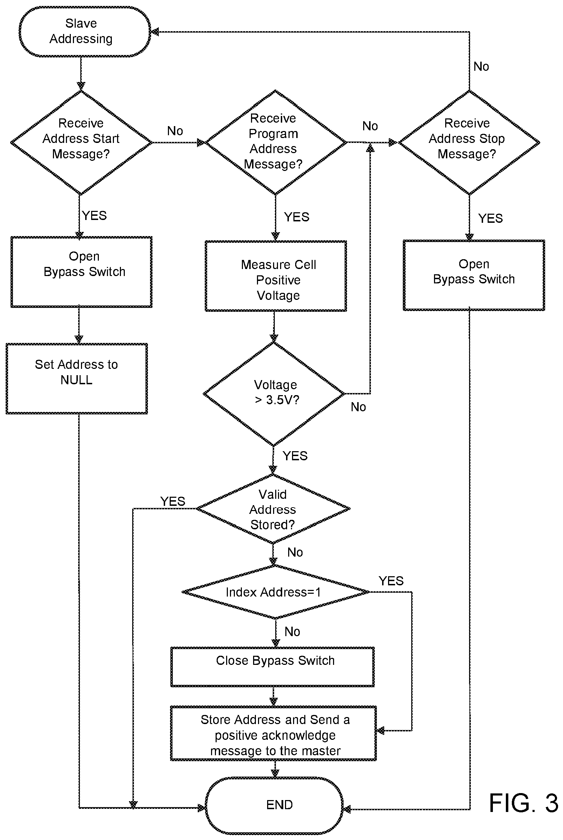

Figure 2 shows a diagram of a cell addressing algorithm for the master controller and Figure 3 shows a diagram of a battery module addressing algorithm. The embodiments of Figs. 2 and 3 are not limiting, and pertain to an approach where the addressing process is controlled in a more centralized manner. As mentioned above, and also described in more detail below, the nodes themselves may also have logic that is more distributed so that they can govern more aspects of the address assignment protocol individually.

As show in FIG. 2, the master controller initiates a cell addressing protocol by transmitting an "Address Start" signal to the battery modules on the Lin Bus Connection line. Each of the battery modules receives this "Address Start" signal and opens respective bypass switch and also sets their address to NULL, as shown in FIG. 3. The master controller 20 then turns on the address power supply to provide power to the batteries modules for addressing purposes. Since all of the bypass switches are open, only the first node 40 will have a node voltage at its addressing power signal receiving terminal, as supplied by the address power supply 28, that is above the threshold voltage value. The master controller 20 then transmits a "Program Address" command through the Lin Bus connection line to all of the battery modules 40. The Program Address signal may contain the address to be assigned, or in some embodiments a message containing the address to be assigned may be sent separately. All of the battery modules or nodes in the series of batteries measure their respective node voltage. The first battery node 40, the only node having a node voltage at its addressing power signal receiving terminal above the threshold voltage optionally sends a "Voltage Acknowledgement" to the master through the Lin Bus connection line via the communication transceiver 46. The first battery node's processor 52 also stores the first node index value provided by the master controller, such as (n), wherein n is the number of battery nodes connected in series, in the first battery node microprocessor. The first battery module 50 then closes the first battery node bypass switch and sends an "Address Acknowledgment" to the master controller 20 that the index value has been stored. That serves as a confirmation message to the master controller 20, and possibly the other nodes 40, that the first address has been assigned to that first node.

Preferably, but optionally, the master controller checks to make sure either the Voltage Acknowledgement message of the Address Acknowledgement message is sent within a pre-set time period, as discussed above. This informs the controller that the addressing process is proceeding in good manner. If the time period passes without the relevant message being received, that may dictate an error in the addressing process. That may require the process to re-start, or that a warning signal be sent for servicing or the like. In the illustrated process, the time period is measured relative to the Voltage Acknowledgement message, but it may be tied to any other event, such as the Address Acknowledgement.

In this embodiment, the number of nodes to be assigned is known, and hence the master controller 20 may start with the highest address available, and "count down" to a final address. The use of decreasing addresses is not necessary, and any order of address assignments can be used. For example, the master controller could assign addresses in an increasing manner 1 through N also, and stop at N. In this embodiment, the range of addresses is pre-set, and that avoids the need to build overcurrent protection into the system for the situation where the last node by-pass switch has closed and the power supply 28 is shorted to ground 47. Alternatively, current protection may be built into the system, and avoiding the use of it is an optional cost-savings and complexity reduction advantage that is not necessary to the practice of the invention. For purposes of convenience, the first node address may be regarded as node 1, and the last as node N, in reference to the order of addressing. That does not mean that the first address must be 1 and the last must be N. The addresses themselves may be different from the addressing sequence (e.g., a series of nodes 1 to N may have addresses 1 to N, N to 1, or anything else).

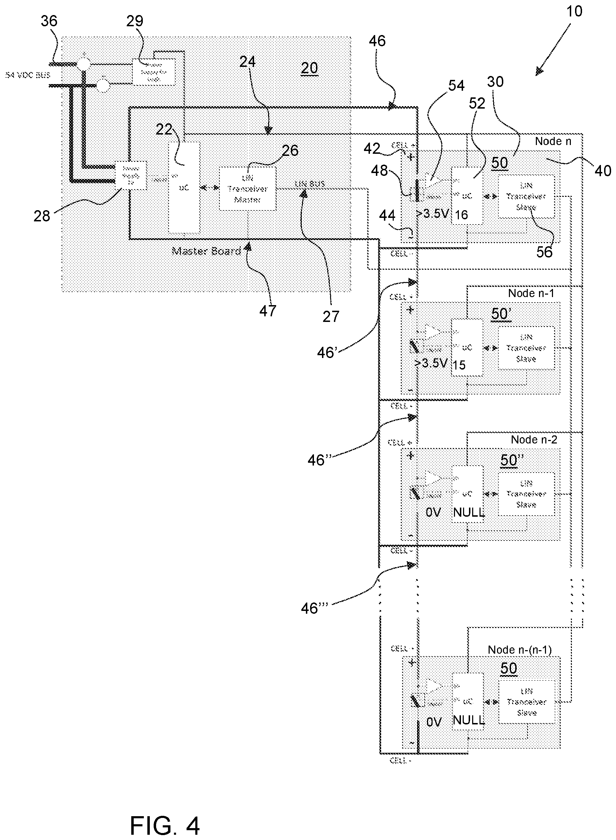

After the first battery node is addressed and its address has been assigned and its bypass switch has been closed, the master then sends a subsequent "Program Address" command to all of the battery modules. Again, all of the battery nodes measure their respective node voltage. In some embodiments, a node (e.g., the first node) that has already been assigned an address need not perform this step. Alternatively, it may perform this step, but the sensor may not sense a voltage above the threshold due to the addressing power signal by-passing the node through its closed by-pass switch. The second battery module now also has a node voltage that is above the threshold value applied to its addressing power signal receiving terminal, since the first node's bypass switch is closed, as depicted in FIG. 4. The second battery node therefore performs the same process the first node did as described above. The second battery node's processor 50' causes its transceiver 56' to send a Voltage Acknowledgment n to the master (and possibly the other nodes) that it is above the threshold voltage value, preferably within the threshold time, through the Lin Bus connection line. Upon receipt of this Voltage Acknowledgment from the second battery node within the threshold time period, such as one second, as shown in FIG. 2, the master then decrements the node index value, n-1, and provides this value to the second node. The second battery module receives and stores this decremented index value, n-1, for example. The second battery module then closes the bypass switch and sends a positive "Address Acknowledgement" message to the master controller. This process is repeated until the last battery node in the series of batteries is addressed.

In an exemplary embodiment, when the last battery node has stored the decremented address index value of one and provided an Address Acknowledgement message to the master controller, the master controller transmits an "Address Stop" signal to the battery modules through Lin Bus connection line. In an alternative embodiment, when last battery node stores a node of address of one, the bypass switch is left open and when the master sends a subsequent "Program Address" command, it will not receive an acknowledgment within the threshold time, as shown in FIG.2, as each of the battery nodes has already stored an address. The master controller therefore turns off the address power supply, and transmits an "Address Stop" signal to the battery modules through Lin Bus connection line. Each of the battery nodes may be programed to keep the bypass switch open in the event that the address received and stored is one, as this will prevent shorting of the address power supply. This process automatically addresses each of the batteries nodes with a series of batteries with an address that is sequential in order. The initial address index value may be set by a user or may be automatically set by a diagnostic that is run by the master controller prior to running the addressing algorithm as shown in FIGS. 2 and 3. It is to be understood that the first battery node in the series of batteries may have an address index value of n, and this value may be input by an operator into the master controller prior to automatic cell addressing. In an exemplary embodiment, the automatic cell addressing algorithm, as provide herein, addresses the batteries nodes in sequential order from n to 1, wherein n is the number of batteries in the series of batteries. In an alternative embodiment, when the master controller indexes the node address value and this value is zero, or a preset number, the master may then send an "Address Stop" signal.

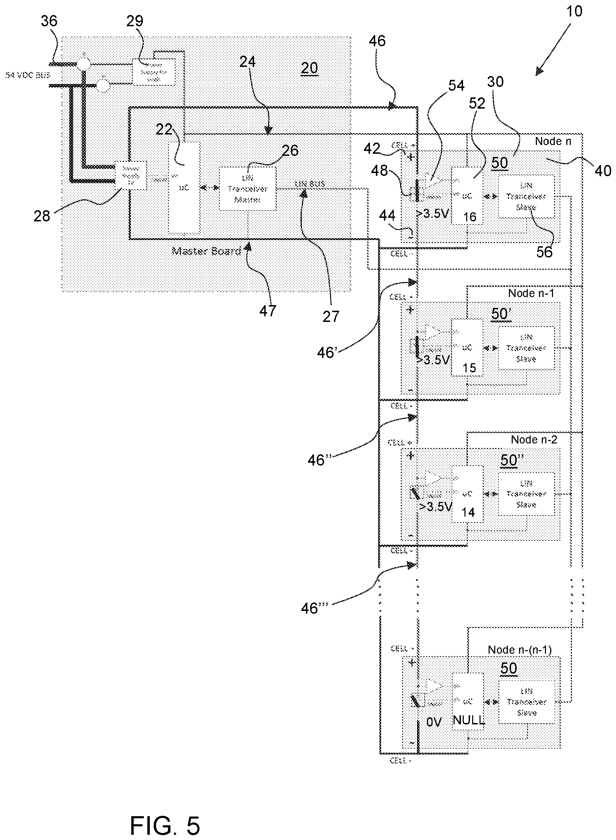

As shown in FIG. 4, the first battery node has been addressed by the master controller, as described herein. The first and second battery nodes now have a node voltage, as supplied by the address power supply to the addressing power signal receiving terminal. The first battery node, 50 has been addressed as node 16 and the second battery node has been addressed with a node value of 15. The second battery node may now close the bypass switch and send an "Address Acknowledgment" to the master controller. After the second battery node closes the bypass switch, the third battery node, 50" now has a voltage as supplied by the address power supply, as shown in FIG. 5. The battery nodes subsequent in the series of batteries from the third battery node still have no voltage, since the third battery node still has an open bypass switch. As shown in FIG. 5, the master controller has sent a "Program Address" command and the third battery node has sent a Voltage Acknowledgment to the master through the Lin Bus connection line 27 and has been address as node 14. This process is continued until all the battery nodes have been automatically addressed. The bypass switch enables commands to be sent to all the battery nodes through the Lin Bus connection line with addressing being sequential due to the sequential closing of the node bypass switches.

In another embodiment, some of the addressing logic may be distributed to the processors 52 in the battery nodes 40 themselves. This allows for more flexibility in using the master controller 20 with different system configurations, in particular different numbers of nodes in series. For example, the processor 52 in each node may be configured with logic (either by software programming or circuit logic, or both) to know what the next available address for assignment is. This would be established as a protocol common to each node. For example, each node could have stored a range of 100 addresses, or logic that enables it to manipulate the address of the most previously assigned address in the system to add one increment to create the next available address. That is, the manipulation or calculation could that, if the last assigned address is 8, the node would increment that to know that the next available address is 9 and use that in the event its sensor 54 detects the addressing power supply signal is applied to its addressing power receiving terminal.

Thus, in such an embodiment, the message confirming assignment of the address of any given node 40 is sent by its transceiver 56 to each other node (and received by their transceivers). In response each unassigned node's processor 52 identifies the next available address for assignment in the subsequent node address assignment. When a subsequent node 40 senses the addressing power signal applied to its receiving terminal (by sensor 54), it will use that address assignment and send out the same message so the remaining unassigned nodes can again identify the next available address for assignment. This is repeated for all the nodes in sequence. As an option in this embodiment, in response to receiving the message confirming assignment of the address via its transceiver, the master controller 20 may also identify the address as assigned in its processor 22. This enables the master controller to determine which addresses have been assigned, so that it has a record for use during normal charging/discharging operations. Alternatively, the master controller may use a separate algorithm, such as a reporting functionality, to collect the addresses assigned after completion of the addressing process.

In this embodiment, the completion of the addressing process may be detecting a condition associated with the closure of the by-pass switch of the last cell. For example, if an overcurrent protector is used, sensing of the overcurrent may terminate the addressing power signal and signal the completion of the process. Similarly, a circuit element installed after the last cell may also signal the end of the process without an overcurrent situation, such as using a resistor or other circuit that receives the signal shorted through all the by-pass switches and can signal completion of the process.

Any addressing method of the invention may be used at the initial installation of the battery system, after servicing of the system, or may be periodically done as a precaution to ensure all cells have been properly addressed. For example, if a cell has failed and been replaced by another cell during servicing, that cell will not have an address. By rerunning the addressing process, the replacement cell will be automatically assigned an address. This allows for easy replacement of cells without the service technician needing to do any address programming manually.

The algorithms and methodologies performed herein are performed under the control of the relevant processor associated with the component performing the relevant function. For example, steps performed by and messages issued by the master controller 20 are performed under the control of its processor 22. The steps performed by and the messages issued by a node 40 or battery module 50 are performed under the control of its processor 52.

It will be apparent to those skilled in the art that various modifications, combinations and variations can be made in the present invention without departing from the scope of the invention. Specific embodiments, features and elements described herein may be modified, and/or combined in any suitable manner. Thus, it is intended that the present invention cover the modifications, combinations and variations of this invention provided they come within the scope of the appended claims and their equivalents.

## Claims

1. A method of automatically assigning a plurality of addresses to a plurality of battery nodes (40) in a battery system comprising:
an addressing power supply (28) for outputting an addressing power signal;
a plurality of battery nodes 1 to N connected in series and each coupled to at least one battery (30);
each node comprising a positive terminal (42), a negative terminal (44), and a bypass switch (48) between the positive and negative terminals, one of the terminals also being an addressing power signal receiving terminal;
each node further comprising a battery module (50) comprising a processor (52), a sensor (54) coupled to the processor for sensing the addressing power signal when applied to the addressing power signal receiving terminal thereof and a communication transceiver (56) coupled to the processor for transmitting and receiving data;
a master controller (20) comprising a processor (22) and a communication transceiver (26) for transmitting and receiving data;
wherein the transceiver of the master controller and the transceiver of each battery module are configured for communication with each other;
the method being performed with all said by-pass switches of the battery nodes being initially open and each node being de-coupled from power connection to the at least one battery associated therewith, the method comprising:
outputting the addressing power signal from the addressing power supply to the addressing power signal receiving terminal of the battery node 1;
**characterised by** at each battery node in sequential order for nodes 1 to N as the addressing power signal is applied to the addressing power signal terminal thereof, performing a node address assignment comprising:
(i) sensing the addressing power signal at the addressing power signal receiving terminal thereof;
(ii) assigning a next available address in the plurality of addresses to the battery node;
(iii) transmitting a message confirming assignment of the address via the communication transceiver of the node to the communication transceivers of the master controller and/or each other node;
wherein during the node address assignment the by-pass switch of the battery node is closed to by-pass the node for at least node 1 to N-1 to apply the addressing power signal to the addressing power signal receiving terminal of the subsequent node.

2. A method according to claim 1, wherein the message confirming assignment of the address is transmitted to the master controller (20), and in response the master controller transmits a message to the nodes (40) identifying the next available address for assignment in the subsequent node address assignment.

3. A method according to claim 1, wherein the message confirming assignment of the address is sent to each other node (40), and in response each unassigned node's processor (52) identifies the next available address for assignment in the subsequent node address assignment.

4. A method according to claim 3, wherein in response to receiving the message confirming assignment of the address, the master controller (20) identifies the address as assigned in its processor (22).

5. A method according to claim 1, wherein the sensing the addressing power signal at the addressing power signal receiving terminal thereof comprising sensing a threshold voltage above a threshold level at the addressing power signal receiving terminal.

6. A method according to claim 1, wherein the during the node address assignment the by-pass switch (48) of the battery node Ni (40) is also closed.

7. A method according to claim 1, wherein the during the node address assignment the by-pass switch (48) of the battery node N (40) remains open.

8. A battery system configured for assigning a plurality of addresses to a plurality of battery nodes (40), comprising:
an addressing power supply (28) for outputting an addressing power signal;
a plurality of battery nodes 1 to N connected in series and each coupled to at least one battery (30);
each node comprising a positive terminal (42), a negative terminal (44), and a bypass switch (48) between the positive and negative terminals, one of the terminals also being an addressing power signal receiving terminal;
each node (40) further comprising a battery module (50) comprising a processor (52), a sensor (54) coupled to the processor for sensing the addressing power signal when applied to the addressing power signal receiving terminal thereof and a communication transceiver (56) coupled to the processor for transmitting and receiving data;
a master controller (20) comprising a processor (22) and a communication transceiver (26) for transmitting and receiving data;
wherein the transceiver of the master controller and the transceiver of each battery module are configured for communication with each other;
the battery system being configured to perform a method of assigning the plurality of addresses to the battery nodes with all said by-pass switches of the battery nodes being initially open and each node being de-coupled from power connection to the at least one battery associated therewith by:
the master controller being configured to cause the addressing power supply to output the addressing power signal from the addressing power supply to the addressing power signal receiving terminal of the battery node 1;
**characterised by** each battery node being configured to perform a node address assignment, in sequential order for nodes 1 to N as the addressing power signal is applied to the addressing power signal terminal thereof, comprising:
(i) sensing the addressing power signal at the addressing power signal receiving terminal thereof with the sensor thereof;
(ii) storing a next available address in the plurality of addresses in the processor thereof;
(iii) transmitting a message confirming assignment of the address via the communication transceiver thereof to the communication transceivers of the master controller and/or each other node;
wherein the processor of each node is configured to close the by-pass switch thereof during the node address assignment to by-pass the node for at least node 1 to N-1 to apply the addressing power signal to the addressing power signal receiving terminal of the subsequent node.

## Patentansprüche

1. Verfahren zum automatischen Zuweisen mehrerer Adressen zu mehreren Batterieknoten (40) in einem Batteriesystem, das Folgendes umfasst:
eine Adressierungsleistungsversorgung (28) zum Ausgeben eines Adressierungsleistungssignals;
mehrere Batterieknoten 1 bis N, die in Reihe geschaltet sind und jeweils mit wenigstens einer Batterie (30) gekoppelt sind;
wobei jeder Knoten einen Pluspol (42), einen Minuspol (44) und einen Überbrückungsschalter (48) zwischen dem Plus- und dem Minuspol umfasst, wobei einer der Pole ebenso ein Adressierungsleistungssignalempfangspol ist;
wobei jeder Knoten ferner ein Batteriemodul (50) umfasst, das einen Prozessor (52), einen Sensor (54), der mit dem Prozessor zum Erfassen des Adressierungsleistungssignals gekoppelt ist, wenn es an den Adressierungsleistungssignalempfangspol davon angelegt wird, und einen Kommunikations-Transceiver (56) umfasst, der zum Übertragen und Empfangen von Daten an den Prozessor gekoppelt ist;
einen Hauptregler (20), der einen Prozessor (22) und einen Kommunikations-Transceiver (26) zum Übertragen und Empfangen von Daten umfasst;
wobei der Transceiver des Hauptreglers und der Transceiver jedes Batteriemoduls für eine Kommunikation miteinander konfiguriert sind;
wobei das Verfahren durchgeführt wird, wenn alle Überbrückungsschalter der Batterieknoten anfänglich geöffnet sind und jeder Knoten von der Leistungsverbindung zu der wenigstens einen Batterie, die damit verbunden ist, entkoppelt ist, wobei das Verfahren Folgendes umfasst:
Ausgeben des Adressierungsleistungssignals von der Adressierungsleistungsversorgung an den Adressierungsleistungssignalempfangspol des Batterieknotens 1;
**gekennzeichnet durch**, an jedem Batterieknoten in sequentieller Reihenfolge für die Knoten 1 bis N, während das Adressierungsleistungssignal an den Adressierungsleistungssignalpol davon angelegt wird, ein Durchführen einer Knotenadressenzuweisung, die Folgendes umfasst:
i) Erfassen des Adressierungsleistungssignals an dem Adressierungsleistungssignalempfangspol davon;
ii) Zuweisen einer nächsten verfügbaren Adresse in den mehreren Adressen zu dem Batterieknoten;
iii) Übertragen einer Nachricht, die die Zuweisung der Adresse bestätigt, über den Kommunikations-Transceiver des Knotens an die Kommunikations-Transceiver des Hauptreglers und/oder jeden anderen Knoten;
wobei während der Knotenadressenzuweisung der Überbrückungsschalter des Batterieknotens geschlossen ist, um den Knoten für wenigstens die Knoten 1 bis N-1 zu überbrücken, um das Adressierungsleistungssignal an den Adressierungsleistungssignalempfangspol des nachfolgenden Knotens anzulegen.

2. Verfahren nach Anspruch 1, wobei die Nachricht, die die Zuweisung der Adresse bestätigt, an den Hauptregler (20) übertragen wird, und als Reaktion darauf der Hauptregler eine Nachricht an die Knoten (40), die die nächste verfügbare Adresse für eine Zuweisung in der nachfolgenden Knotenadresszuweisung identifizieren, überträgt.

3. Verfahren nach Anspruch 1, wobei die Nachricht, die die Zuweisung der Adresse bestätigt, an jeden anderen Knoten (40) übertragen wird, und als Reaktion darauf der Prozessor (52) jedes nicht zugewiesenen Knotens die nächste verfügbare Adresse für die Zuweisung in der nachfolgenden Knotenadresszuweisung identifiziert.

4. Verfahren nach Anspruch 3, wobei als Reaktion auf das Empfangen der Nachricht, die die Zuweisung der Adresse bestätigt, der Hauptregler (20) die Adresse als in seinem Prozessor (22) zugewiesen identifiziert.

5. Verfahren nach Anspruch 1, wobei das Erfassen des Adressierungsleistungssignals an dem Adressierungsleistungssignalempfangspol davon das Erfassen einer Schwellenspannung über einem Schwellenpegel an dem Adressierungsleistungssignalempfangspol umfasst.

6. Verfahren nach Anspruch 1, wobei während der Knotenadresszuweisung der Überbrückungsschalter (48) des Batterieknotens Ni (40) ebenso geschlossen ist.

7. Verfahren nach Anspruch 1, wobei während der Knotenadresszuweisung der Überbrückungsschalter (48) des Batterieknotens N (40) geöffnet bleibt.

8. Batteriesystem, das zum Zuweisen mehrerer Adressen an mehrere Batterieknoten (40) konfiguriert ist, das Folgendes umfasst:
eine Adressierungsleistungsversorgung (28) zum Ausgeben eines Adressierungsleistungssignals;
mehrere Batterieknoten 1 bis N, die in Reihe geschaltet sind und jeweils mit wenigstens einer Batterie (30) gekoppelt sind;
wobei jeder Knoten einen Pluspol (42), einen Minuspol (44) und einen Überbrückungsschalter (48) zwischen dem Plus- und dem Minuspol umfasst, wobei einer der Pole ebenso ein Adressierungsleistungssignalempfangspol ist;
wobei jeder Knoten (40) ferner ein Batteriemodul (50) umfasst, das einen Prozessor (52), einen Sensor (54), der mit dem Prozessor zum Erfassen des Adressierungsleistungssignals gekoppelt ist, wenn es an den Adressierungsleistungssignalempfangspol davon angelegt wird, und einen Kommunikations-Transceiver (56) umfasst, der zum Übertragen und Empfangen von Daten an den Prozessor gekoppelt ist;
einen Hauptregler (20), der einen Prozessor (22) und einen Kommunikations-Transceiver (26) zum Übertragen und Empfangen von Daten umfasst;
wobei der Transceiver des Hauptreglers und der Transceiver jedes Batteriemoduls für eine Kommunikation miteinander konfiguriert sind;
wobei das Batteriesystem konfiguriert ist, um ein Verfahren zum Zuweisen der mehreren Adressen an die Batterieknoten durchzuführen, wenn alle Überbrückungsschalter der Batterieknoten anfänglich geöffnet sind und jeder Knoten von der Leistungsverbindung zu der wenigstens einen Batterie, die damit verbunden ist, entkoppelt ist, durch Folgendes:
die Hauptsteuerung ist konfiguriert, um die Adressierungsleistungsversorgung zu veranlassen, das Adressierungsleistungssignal von der Adressierungsleistungsversorgung an den Adressierungsleistungssignalempfangspol des Batterieknotens 1 auszugeben;
**gekennzeichnet dadurch, dass** jeder Batterieknoten konfiguriert ist, um eine Knotenadressenzuweisung durchzuführen, in sequentieller Reihenfolge für die Knoten 1 bis N, während das Adressierungsleistungssignal an den Adressierungsleistungssignalpol davon angelegt wird, die Folgendes umfasst:
i) Erfassen des Adressierungsleistungssignals an dem Adressierungsleistungssignalempfangspol davon mit dem Sensor davon;
ii) Speichern einer nächsten verfügbaren Adresse in den mehreren Adressen in dem Prozessor davon;
iii) Übertragen einer Nachricht, die die Zuweisung der Adresse bestätigt, über den Kommunikations-Transceiver davon an die Kommunikations-Transceiver des Hauptreglers und/oder jeden anderen Knoten;
wobei der Prozessor jedes Knotens konfiguriert ist, um den Überbrückungsschalter davon während der Knotenadressenzuweisung zu schließen, um den Knoten für wenigstens die Knoten 1 bis N-1 zu überbrücken, um das Adressierungsleistungssignal an den Adressierungsleistungssignalempfangspol des nachfolgenden Knotens anzulegen.

## Revendications

1. Procédé d'attribution automatique d'une pluralité d'adresses à une pluralité de nœuds de batterie (40) dans un système de batterie comprenant :
une alimentation d'adressage (28) pour émettre un signal d'alimentation d'adressage ;
une pluralité de nœuds de batterie 1 à N connectés en série et chacun couplé à au moins une batterie (30) ;
chaque nœud comprenant une borne positive (42), une borne négative (44) et un commutateur de dérivation (48) entre les bornes positive et négative, l'une des bornes étant également une borne de réception de signal d'alimentation d'adressage ;
chaque nœud comprenant en outre un module de batterie (50) comprenant un processeur (52), un capteur (54) couplé au processeur pour détecter le signal d'alimentation d'adressage lorsqu'il est appliqué à sa borne de réception de signal d'alimentation d'adressage et un émetteur-récepteur de communication (56) couplé au processeur pour transmettre et recevoir des données ;
un dispositif de commande maître (20) comprenant un processeur (22) et un émetteur-récepteur de communication (26) pour émettre et recevoir des données ;
l'émetteur-récepteur du dispositif de commande maître et l'émetteur-récepteur de chaque module de batterie étant configurés pour communiquer l'un avec l'autre ;
le procédé étant exécuté avec tous lesdits commutateurs de dérivation des nœuds de batterie étant initialement ouverts et chaque nœud étant découplé de la connexion d'alimentation à l'au moins une batterie qui lui est associée, le procédé comprenant :
la livraison du signal d'alimentation d'adressage de l'alimentation d'adressage à la borne de réception du signal d'alimentation d'adressage du nœud de batterie 1 ;
**caractérisé par**, au niveau de chaque nœud de batterie, dans un ordre séquentiel pour les nœuds 1 à N, lorsque le signal d'alimentation d'adressage est appliqué à la borne de signal d'alimentation d'adressage de ce dernier, la réalisation d'une attribution d'adresse de nœud comprenant :
(i) la détection du signal d'alimentation d'adressage au niveau de sa borne de réception de signal d'alimentation d'adressage ;
(ii) l'attribution d'une adresse disponible suivante dans la pluralité d'adresses au nœud de batterie ;
(iii) la transmission d'un message confirmant l'attribution de l'adresse par l'intermédiaire de l'émetteur-récepteur de communication du nœud aux émetteurs-récepteurs de communication du dispositif de commande maître et/ou de chaque autre nœud ;
pendant l'attribution d'adresse de nœud, le commutateur de dérivation du nœud de batterie étant fermé pour contourner le nœud pendant au moins le nœud 1 à N-1 afin d'appliquer le signal d'alimentation d'adressage à la borne de réception de signal d'alimentation d'adressage du nœud suivant.

2. Procédé selon la revendication 1, le message confirmant l'attribution de l'adresse étant transmis au dispositif de commande maître (20), et en réponse le dispositif de commande maître transmet un message aux nœuds (40) identifiant la prochaine adresse disponible pour l'attribution dans la prochaine attribution d'adresse de nœud.

3. Procédé selon la revendication 1, le message confirmant l'attribution de l'adresse étant envoyé à chaque autre nœud (40), et en réponse le processeur (52) de chaque nœud non attribué identifie la prochaine adresse disponible pour l'attribution dans l'attribution d'adresse de nœud ultérieure.

4. Procédé selon la revendication 3, en réponse à la réception du message confirmant l'attribution de l'adresse, le dispositif de commande maître (20) identifiant l'adresse telle qu'attribuée dans son processeur (22).

5. Procédé selon la revendication 1, la détection du signal d'alimentation d'adressage au niveau de la borne de réception de signal d'alimentation d'adressage comprenant la détection d'une tension de seuil au-dessus d'un niveau de seuil au niveau de la borne de réception de signal d'alimentation d'adressage.

6. Procédé selon la revendication 1, pendant l'attribution d'adresse de nœud, le commutateur de dérivation (48) du nœud de batterie Ni (40) étant également fermé.

7. Procédé selon la revendication 1, pendant l'attribution d'adresse de nœud, le commutateur de dérivation (48) du nœud de batterie N (40) restant ouvert.

8. Système de batterie configuré pour attribuer une pluralité d'adresses à une pluralité de nœuds de batterie (40), comprenant :
une alimentation d'adressage (28) pour émettre un signal d'alimentation d'adressage ;
une pluralité de nœuds de batterie 1 à N connectés en série et chacun couplé à au moins une batterie (30) ;
chaque nœud comprenant une borne positive (42), une borne négative (44) et un commutateur de dérivation (48) entre les bornes positive et négative, l'une des bornes étant également une borne de réception de signal d'alimentation d'adressage ;
chaque nœud (40) comprenant en outre un module de batterie (50) comprenant un processeur (52), un capteur (54) couplé au processeur pour détecter le signal d'alimentation d'adressage lorsqu'il est appliqué à sa borne de réception de signal d'alimentation d'adressage et un émetteur-récepteur de communication (56) couplé au processeur pour transmettre et recevoir des données ;
un dispositif de commande maître (20) comprenant un processeur (22) et un émetteur-récepteur de communication (26) pour émettre et recevoir des données ;
l'émetteur-récepteur du dispositif de commande maître et l'émetteur-récepteur de chaque module de batterie étant configurés pour communiquer l'un avec l'autre ;
le système de batterie étant configuré pour exécuter un procédé d'attribution de la pluralité d'adresses aux nœuds de batterie, tous lesdits commutateurs de dérivation des nœuds de batterie étant initialement ouverts et chaque nœud étant découplé de la connexion d'alimentation à l'au moins une batterie associée avec cette dernière :
le dispositif de commande maître étant configuré pour amener l'alimentation d'adressage à délivrer le signal d'alimentation d'adressage de l'alimentation d'adressage à la borne de réception de signal d'alimentation d'adressage du nœud de batterie 1 ;
**caractérisé en ce que** chaque nœud de batterie est configuré pour effectuer une attribution d'adresse de nœud, dans un ordre séquentiel pour les nœuds 1 à N lorsque le signal d'alimentation d'adressage est appliqué à la borne de signal d'alimentation d'adressage de ce dernier, comprenant :
(i) la détection du signal d'alimentation d'adressage au niveau de la borne de réception de signal d'alimentation d'adressage de cette dernière au moyen de son capteur ;
(ii) le stockage d'une adresse disponible suivante dans la pluralité d'adresses dans son processeur ;
(iii) la transmission d'un message confirmant l'attribution de l'adresse par l'intermédiaire de l'émetteur-récepteur de communication de ce dernier aux émetteurs-récepteurs de communication du dispositif de commande maître et/ou de chaque autre nœud ;
le processeur de chaque nœud étant configuré pour fermer son commutateur de dérivation pendant l'attribution d'adresse de nœud afin de contourner le nœud pour au moins le nœud 1 à N-1 afin d'appliquer le signal d'alimentation d'adressage à la borne de réception de signal d'alimentation d'adressage du nœud suivant.
